# EUROPEAN PATENT SPECIFICATION

(11) **EP 4 152 026 B1**
(45) Date of publication and mention of the grant of the patent: **25.11.2026**
(21) Application number: 22201854.1
(22) Date of filing: 23.04.2018
(51) Int. Cl.: G01R 33/06, G01D 5/14, G01N 27/90, G01R 33/028, G01R 33/09

(54) **MAGNETIC FIELD SENSOR WITH ERROR CALCULATION**
MAGNETFELDSENSOR MIT FEHLERBERECHNUNG
CAPTEUR DE CHAMP MAGNÉTIQUE AVEC CALCUL D'ERREUR

(30) Priority: 26.05.2017 US 201715606325
(43) Date of publication of application: 22.03.2023
(62) Document number(s) of the earlier application(s) in accordance with Art. 76 EPC: 18723644.3 / 3 631 487
(73) Proprietor: Allegro MicroSystems, LLC, Manchester, NH 03103-3353 (US)
(72) Inventor: ROMERO, Hernán D., 1636 Buenos Aires (AR)
(74) Representative: South, Nicholas Geoffrey

(56) References cited:
- JP-A- H07 128 295
- JP-A- H09 292 471
- US-A1- 2014 333 295
- US-A1- 2015 022 198

## Description

### FIELD

This disclosure relates to magnetic field sensors and, more particularly, to magnetic field sensors with error calculation.

### BACKGROUND

Magnetic field sensors are often used to detect a ferromagnetic target. They often act as sensors to detect motion or position of the target. Such sensors are ubiquitous in many areas of technology including robotics, automotive, manufacturing, etc. For example, a magnetic field sensor may be used to detect when a vehicle's wheel locks up, triggering the vehicle's control processor to engage the anti-lock braking system. In this example, the magnetic field sensor may detect rotation of the wheel. Magnetic field sensor may also detect distance to an object. For example, a magnetic field sensor may be used to detect the position of a hydraulic piston.

No magnetic field sensor is perfectly precise. Every magnetic field sensor that detects the position of a target includes at least some error. In some systems, the error may be a nonlinear error that is a function of the position of the target. Compensating for an error that is a function of the position of the target may pose challenges if the target is used as a reference and/or if the position of the target is unknown when attempting to measure and calculate the error. Document US 2014/333295 A1 describes a magnetic field sensor with enhanced immunity to external magnetic interference. Document JP 07128295 A describes removal of a measurement error resulted from the vibration of a steel plate accompanying conveyance by carrying an exciting current of high frequency remarkable having a remarkable eddy current loss and an exciting current of low frequency having a remarkable hysteresis loss to an exciting coil.

### SUMMARY

According to a first aspect of the invention there is provided a system as defined in claim 1. According to a second aspect of the invention there is provided a method as defined in claim 2.

### BRIEF DESCRIPTION OF THE DRAWINGS

The foregoing features may be more fully understood from the following description of the drawings. The drawings aid in explaining and understanding the disclosed technology. Since it is often impractical or impossible to illustrate and describe every possible embodiment, the provided figures depict one or more exemplary embodiments. Accordingly, the figures are not intended to limit the scope of the invention. Like numbers in the figures denote like elements.
FIG. 1 is a perspective view of a system for sensing a conductive target.
FIG. 2 are cross sectionals view of the system of FIG. 1.
FIG. 3 is a block diagram of a system for sensing a conductive target, including signal processing elements.
FIG. 4 is a block diagram of another embodiment of a system for sensing a conductive target, including signal processing elements.
FIG. 4A is a schematic diagram of a coil and magnetic field sensing elements.
FIG. 5 is a graph of signals associated with the system of FIG. 4.
FIG. 6 is a graph of strength of a reflected magnetic field versus frequency.
FIG. 7 is a timing graph of modes of operation of the system of FIG. 4.

### DETAILED DESCRIPTION

As used herein, the term "magnetic field sensing element" is used to describe a variety of electronic elements that can sense a magnetic field. The magnetic field sensing element can be, but is not limited to, a Hall Effect element, a magnetoresistance element, or a magnetotransistor. As is known, there are different types of Hall Effect elements, for example, a planar Hall element, a vertical Hall element, and a Circular Vertical Hall (CVH) element. As is also known, there are different types of magnetoresistance (MR) elements, for example, a semiconductor magnetoresistance element such as Indium Antimonide (InSb), a giant magnetoresistance (GMR) element, an anisotropic magnetoresistance element (AMR), a tunneling magnetoresistance (TMR) element, and a magnetic tunnel junction (MTJ). The magnetic field sensing element may be a single element or, alternatively, may include two or more magnetic field sensing elements arranged in various configurations, e.g., a half bridge or full (Wheatstone) bridge. Depending on the device type and other application requirements, the magnetic field sensing element may be a device made of a type IV semiconductor material such as Silicon (Si) or Germanium (Ge), or a type III-V semiconductor material like Gallium-Arsenide (GaAs) or an Indium compound, e.g., Indium-Antimonide (InSb).

As is known, some of the above-described magnetic field sensing elements tend to have an axis of maximum sensitivity parallel to a substrate that supports the magnetic field sensing element, and others of the above-described magnetic field sensing elements tend to have an axis of maximum sensitivity perpendicular to a substrate that supports the magnetic field sensing element. In particular, planar Hall elements tend to have axes of sensitivity perpendicular to a substrate, while metal based or metallic magnetoresistance elements (e.g., GMR, TMR, AMR) and vertical Hall elements tend to have axes of sensitivity parallel to a substrate.

As used herein, the term "magnetic field sensor" is used to describe a circuit that uses a magnetic field sensing element, generally in combination with other circuits. Magnetic field sensors are used in a variety of applications, including, but not limited to, an angle sensor that senses an angle of a direction of a magnetic field, a current sensor that senses a magnetic field generated by a current carried by a current-carrying conductor, a magnetic switch that senses the proximity of a ferromagnetic object, a rotation detector that senses passing ferromagnetic articles, for example, magnetic domains of a ring magnet or a ferromagnetic target (e.g., gear teeth) where the magnetic field sensor is used in combination with a back-biased or other magnet, and a magnetic field sensor that senses a magnetic field density of a magnetic field.

As used herein, the terms "target" and "magnetic target" are used to describe an object to be sensed or detected by a magnetic field sensor or magnetic field sensing element.

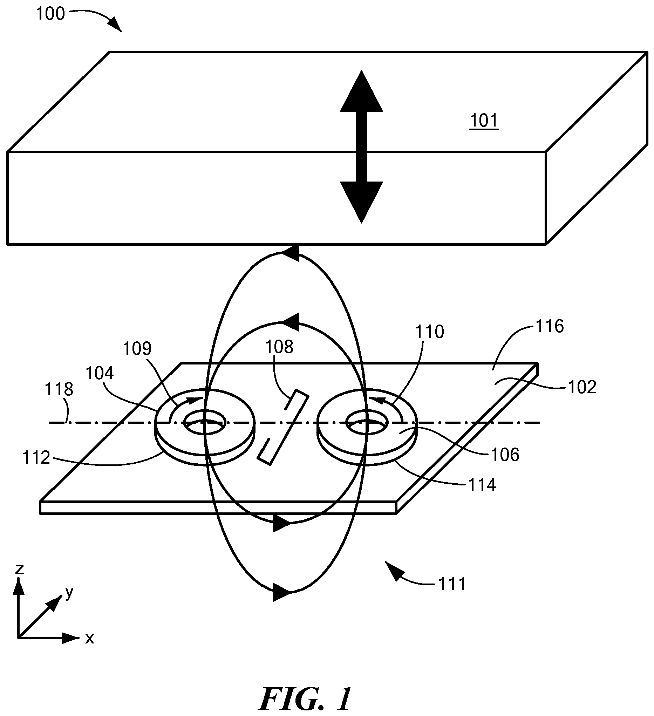

FIG. 1 is a perspective view of a system 100 for detecting a conductive target 101. System 100 may include a substrate 102, which may support coil 104, coil 106, and MR element 108. Although one MR element is shown, MR element 108 may comprise two or more MR elements depending on the embodiment of system 100. In other embodiments, coils 104 and 106 may be supported by separate substrates, or may be free-standing coils (i.e. coils that are not supported by a substrate or that are supported by a different structure such as a chip package or frame).

Target 101 may comprise a conductive material, such as a metal, that allows the magnetic fields produced by coils 104 and 106 to induce eddy currents in target 101.

Although not shown, an MR driver circuit may provide current to MR element 108 and a coil driver circuit may provide current to coils 104 and 106.

Coil 104 and 106 may be arranged so that the current flows through coils 104 and 106 in opposite directions, as shown by arrow 109 (indicating a clockwise current in coil 104) and arrow 110 (indicating a counterclockwise current in coil 106). As a result, coil 104 may produce a magnetic field having a magnetic moment in the negative Z direction (i.e. down, in Figure 1). Similarly, coil 106 may produce a magnetic field having a magnetic moment in the opposite direction, the positive Z direction. An aggregate magnetic field 111 produced by both coils may have a shape similar to that shown by magnetic field lines 111. It will be appreciated that coils 104, 106 may be formed by a single coil structure respectively wound so that the current through the coils flows in opposite directions. Alternatively, coils 104, 106 may be formed by separate coil structures.

In an embodiment, MR element 108 may be positioned between coils 104 and 106. In this arrangement, absent any other magnetic fields aside from those produced by coils 104 and 106, the net magnetic field at MR element 108 may be zero. For example, the negative Z component of the magnetic field produced by coil 104 may be canceled out by the positive Z component of the magnetic field produced by coil 106, and the negative X component of the magnetic field shown above substrate 102 may be canceled out by the positive X component of the magnetic field shown below substrate 102. In other embodiments, additional coils may be added to substrate 102 and arranged so that the net magnetic field at MR element 108 is substantially nil.

To achieve a substantially zero magnetic field at the location of MR element 108, coil 104 and coil 106 may be placed so that current through the coils flows in circular patterns substantially in the same plane. For example, the current through coil 104 and 106 is flowing in circular patterns through the coils. As shown, those circular patterns are substantially coplanar with each other, and with the top surface 116 of substrate 102.

A coil driver (not shown in FIG. 1) coupled to coil 104 and/or 106 may produce an alternating field. In this arrangement, the magnetic field shown by magnetic field lines 111 may change direction and magnitude over time. However, during these changes, the magnetic field at the location of MR element 108 may remain substantially nil.

In operation, as target 101 moves toward and away from MR element 108 (i.e. in the positive and negative Z direction), magnetic field 111 will cause eddy currents to flow within target 101. These eddy currents will create their own magnetic fields, which will produce a non-zero magnetic field in the plane of the MR element 108, which non-zero magnetic field can be sensed to detect the motion or position of target 101.

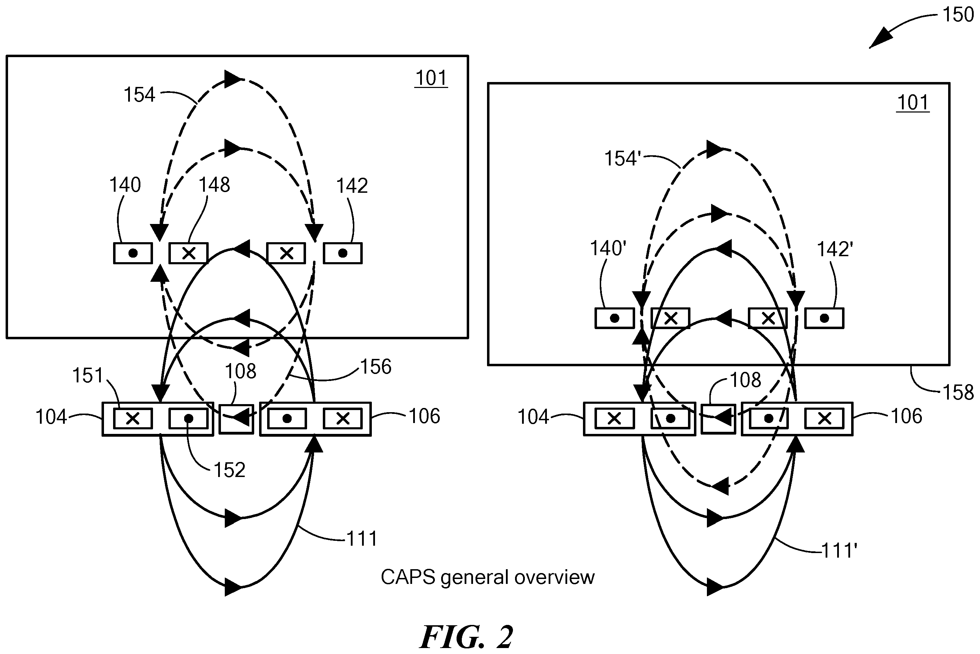

Referring to FIG. 2, a cross-sectional view 150 of system 100, as viewed at line 118 (in FIG. 1) in the Y direction, illustrates the eddy currents within target 101. The 'x' symbol represents a current flowing into the page and the '•' symbol represents a current flowing out of the page. As noted above, the current through coils 104 and 106 may be an alternating current, which may result in an alternating strength of magnetic field 111. In embodiments, the phase of the alternating current through coil 104 matches the phase of the alternating current through coil 106 so that magnetic field 111 is an alternating or periodic field.

Alternating magnetic field 111 may produce eddy currents 140 and 142 within magnetic target 101. Eddy currents 140 and 142 may be opposite in direction to the current flowing through coils 104 and 106, respectively. As shown, eddy current 140 flows out of the page and eddy current 148 flows into the page, while coil current 151 flows into the page and current 152 flows out of the page. Also, as shown, the direction of eddy current 142 is opposite the direction of the current through coil 106.

Eddy currents 140 and 142 generate a reflected magnetic field 154 that has a direction opposite to magnetic field 111. As noted above, MR element 108 detects a net magnetic field of zero due to magnetic field 111. However, MR element 108 will detect a non-zero magnetic field in the presence of reflected magnetic field 154. As illustrated by magnetic field line 156, the value of reflected magnetic field 154 is non-zero at MR element 108.

As target 101 moves closer to coils 104 and 106, magnetic field 111 may produce stronger eddy currents in target 101. As a result, the strength of reflected magnetic field 154 may change. Magnetic field 111' (in the right-hand panel of FIG. 2) may represent a stronger magnetic field than magnetic field 111 due, for example, to the closer proximity of target 101 to coils 104 and 106. Thus, eddy currents 140' and 142' may be stronger currents than eddy currents 140 and 142, and magnetic field 154' may be stronger than magnetic field 154. This phenomenon may result in MR element 108 detecting a stronger magnetic field (i.e. magnetic field 154') when target 101 is closer to coils 104 and 106, and a weaker magnetic field (i.e. magnetic field 154) when target 101 is further away from coils 104 and 106.

Also, eddy currents 140' and 142' generally occur on or near the surface of target 101. Magnetic field strength diminishes as a function of radius-i.e. as a function of distance from the source of the magnetic field. Therefore, as target 101 moves closer to MR element 108, MR element 108 may experience a stronger magnetic field from the eddy currents because the source of the magnetic field is closer to MR element 108.

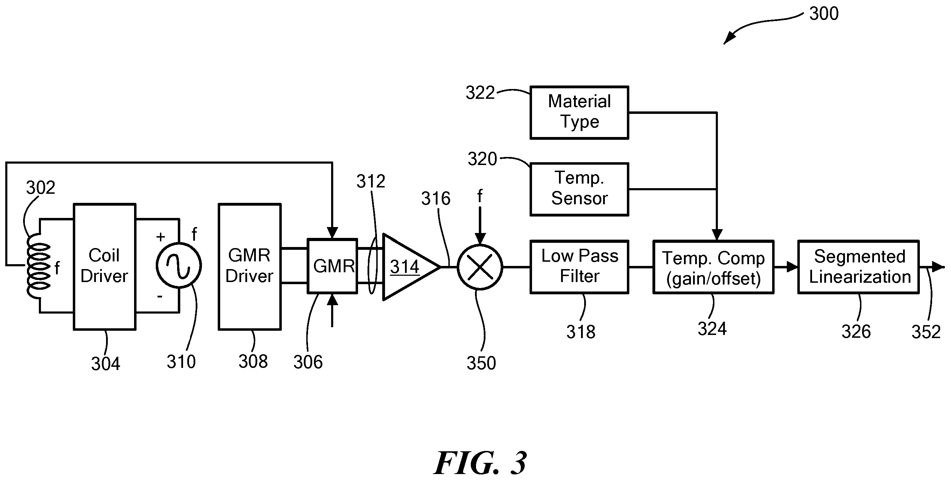

FIG. 3 is a block diagram of a magnetic field sensor 300, which may include coil 302, coil driver 304, AC driver 310, MR driver 308, MR element 306, amplifier 314, low pass filter 318, temperature sensor 320, material type module 322, offset module 324, and segmented linearization module 326.

Although shown as a single coil, coil 302 may comprise one or more coils. In embodiments, coil 302 may be the same as or similar to coil 104 and/or coil 106 described above. Similarly, MR element 306 may comprise one or more MR elements and may be the same as or similar to MR element 108 described above.

Coil driver 304 may provide a power signal that drives current through coil 302, thus causing coil 302 to generate a magnetic field. MR driver 308 may provide power to MR elements 306, allowing them to detect magnetic fields.

MR element 306 may be responsive to a sensing element drive signal (e.g. the signal produced by MR driver 308) and may be configured to detect a directly-coupled magnetic field generated by coil 302. MR element 306 may produce signal 312, representing the detected magnetic field. MR element 306 may also be configured to detect a reflected magnetic field produced by eddy currents within a target, such as target 101.

As shown, AC driver 310 is coupled to coil driver 304. In this embodiment, coil driver 304 produces a low-frequency signal to drive coil 302. The frequency is low enough so that the magnetic field produced by coil 302 does not induce eddy currents and a reflected field from target 101. In some embodiments, the frequency is zero (i.e. a "DC" frequency).

Coil 302 produces a DC (or substantially low frequency AC) magnetic field that can be detected by MR element 306, but which does not produce eddy currents in the target. The signal produced by detection of the DC (or substantially low frequency AC) magnetic field may be used to adjust sensitivity of the magnetic field sensor.

Coil 302 also produces an AC magnetic field at higher frequencies that induces eddy currents in the target, which produce a reflected magnetic field at those higher frequencies that can be detected by MR element 306. Coil 302 alternates between producing the low frequency magnetic field and the high frequency magnetic field.

MR element 306 may produce signal 312, which may include frequency components at DC or substantially low AC frequency (e.g. a "directly coupled" signal or signal component) representing the lower frequency magnetic field that does not cause eddy currents in the target, and/or frequency components at the higher AC frequency (e.g. a "reflected" signal or signal component) that represent the detected reflected field. In embodiments, the directly coupled signals may be used to adjust sensitivity of the sensor while the reflected signals may be used to detect the target. Coil driver 304 and/or MR driver 308 may use the directly coupled signals as a sensitivity signal to adjust their respective output drive signals in response to the sensitivity signal.

In examples not forming part of the claimed subject matter, the directly coupled signal and the reflected signal may be included as frequency components of the same signal. In this case, coil 302 may be driven to produce both frequency components at the same time. In other embodiments according to the claims, the directly coupled signal and the reflected signals are generated at different times, for example using a time-division multiplexing scheme.

Sensor 300 may also include a demodulator circuit 350 that can modulate signal 316 to remove the AC component from the signal or shift the AC component within the signal to a different frequency. For example, demodulator circuit 350 may modulate signal 316 at frequency f. As known in the art, because signal 316 includes signal components at frequency f representing the detected magnetic field, modulating signal 316 at frequency f may shift the signal elements representing the detected magnetic field to 0Hz or DC. Other frequency components within signal 316 may be shifted to higher frequencies so they can be removed by low-pass filter 318. In embodiments, the DC or low frequency component of signal 316, which may represent a sensitivity value, can be fed back to coil driver 304 to adjust the output of coil 302 in response to the signal, and/or to MR driver 308 to adjust drive signal 309 in response to the sensitivity value. DC output signal 352 may represent proximity of the target to MR element 306.

In other embodiments, a time-division multiplexing scheme is used. For example, coil driver 304 drives coil 302 at a first frequency during a first time period, at a second frequency during a second time period, etc. In some instances, the first and second (and subsequent) time periods do not overlap. In other instances, the first and second time periods may overlap. In these instances, coil driver 304 may drive coil 302 at two or more frequencies simultaneously. When the first and second time periods do not overlap, demodulator 350 may operate at the same frequency as the coil driver 304. When the time periods overlap, multiple modulators can be used, the first running at the first frequency, and the second running at the second frequency to separate out the signals at each frequency.

While it can be advantageous to reduce the directly coupled magnetic field that the MR element 306 detects to achieve an accurate read of the reflected field (and thus the detected target), it may also be advantageous to have some amount of direct coupling (i.e., to directly detect the magnetic field produced by coil 302) to permit a sensitivity value to be computed. The simultaneous measure of both the field reflected by the target and the field directly generated by the coil allows accurate detection of the distance of the object independent of the sensitivity of the MR elements, coil drive current, etc. The sensitivity of MR elements may vary with temperature and/or with the presence of unwanted DC or AC stray fields in the plane of the MR array. The ratio between the reflected field and the directly coupled field is just dependent on geometrical design and is hence a good parameter to accurately determine a distance.

In embodiments, a frequency hopping scheme may be used. For example, coil driver 304 drives coil 302 at different frequencies (e.g. alternate between frequencies over time, or produce a signal containing multiple frequencies). In such embodiments, sensor 300 may include multiple demodulator circuits and/or filters to detect a signal at each frequency.

Additional examples of magnetic field sensors that use a coil and reflected field may be found in U.S. Patent Application entitled COIL ACTUATED POSISTION SENSOR WITH REFLECTED MAGNETIC FIELD, which lists Mr. A. Latham as an inventor, is commonly owned with this application, was filed on the same day as this application, is identified by attorney docket number ALLEG-590PUS, was granted application number 15/606,358.

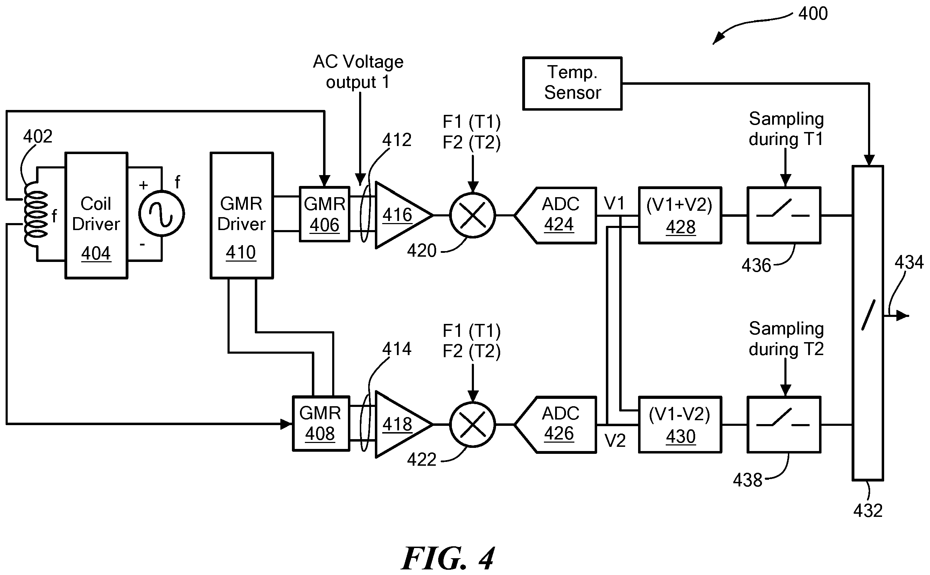

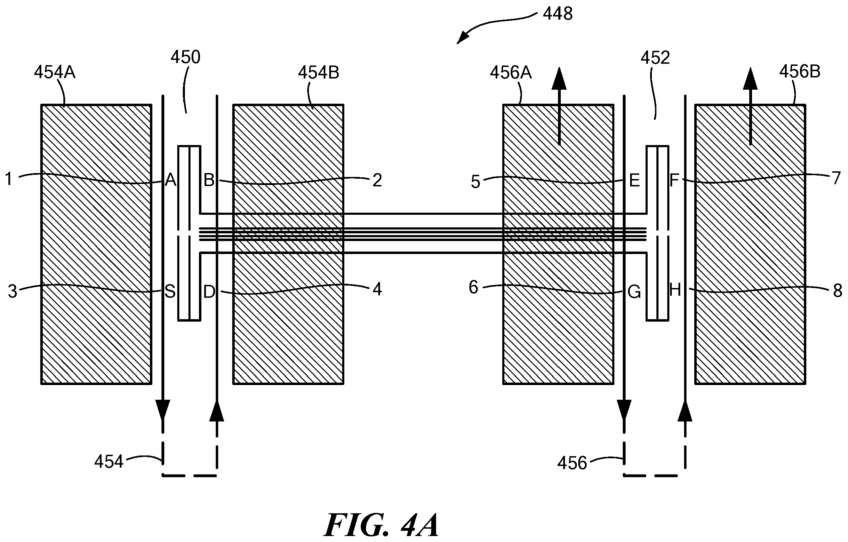

FIG. 4 is a block diagram of a magnetic field sensor 400 for detecting a conductive target. Magnetic field sensor 400 includes coil 402 for generating a magnetic field, coil driver 404 to drive current through coil 402, and magnetic field sensing elements 406 and 408 to detect magnetic fields. Coil driver 404 may be an adjustable coil driver that can drive current of different magnitude and different frequency through coil 402. For example, coil driver 404 drives an AC current having a first frequency during a first time period, and a current with second frequency during a second time period. In embodiments, the first frequency is high enough to produce eddy currents in, and a reflected magnetic field from, the conductive target, and the second frequency is low enough so that any reflected field from the conductive target is substantially undetectable by magnetic field sensing elements 406 and 408. In embodiments, the second frequency may be a zero-frequency or "DC" frequency.

Magnetic field sensing elements 406 and 408 may be MR elements, Hall effect elements, or other types of magnetic field sensing element. In embodiments, magnetic field sensing elements 406 and 408 shown in FIG. 4 may represent multiple Hall effect or MR elements. For example, each block 406 and 408 may represent two, four, or more magnetic field sensing elements arranged in a bridge formation to produce differential output signals 412 and 414, respectively. In other embodiments, magnetic field sensing elements 406 and 408 may produce single ended output signals.

Magnetic field sensing elements 406 and 408 may detect a directly coupled magnetic field (i.e. they may directly detect the magnetic field produced by coil 402), and may detect a reflected field produced by eddy currents in the conductive target (e.g. target 101 in FIG. 1). In embodiments, magnetic field sensing elements 406 and 408 may be arranged so that their axes of maximum sensitivity are in opposite directions. For example, when sensing the directly coupled field, MR element 406 may produce a signal having the same absolute value, but opposite sign to the signal produced by MR element 408. The axes of maximum sensitivity may also be arranged so that the signals produced when MR elements 406 and 408 detect the reflected magnetic field do not have opposite signs. In embodiments, this may be effectuated by including a counter-coil in coil 402.

Referring to FIG. 4A, coil 448 may be the same as or similar to coil 402. MR elements 1-4 may comprise or may be the same as or similar to MR element 406, and MR elements 5-8 may comprise or may be the same as or similar to MR element 408. For example, MR elements 1-4 may form an MR bridge that is the same as or similar to MR element 406, and MR elements 5-8 may form an MR bridge that is the same as or similar to MR element 408.

Coil 452 may include traces 454A, 454B, 456A, and 456B, and countercoil portions 454 and 456. The countercoil portions 454 and 456 may produce a local magnetic field around MR elements that reduces the response of MR elements 1-8 to the reflected magnetic field and increases the response of MR elements 108 to the directly coupled field. The local magnetic field produced by countercoil portions 454 and 456 may have a direction opposite to that of the magnetic field produced by traces 454A, 454B, 456A, and 456B.

In FIG. 4A, current through countercoil portions 454 and 456 is shown to travel in a counterclockwise direction. Although not shown, in other embodiments, current through countercoil portions 454 and 456 may travel in a counterclockwise direction.

The differential output of the bridge comprising MR elements 1-4 may be defined as the voltage at the series connection node between MR elements 1 and 4 less the voltage at the series connection node between MR elements 2 and 3, and the differential output of the bridge comprising MR elements 5-8 may be defined as the voltage at the series connection node between MR elements 5 and 8 less the voltage at the series connection node between MR elements 6 and 7. Considering the case where there is no reflected field, the directly coupled field experienced by MR elements 1 and 4 may be opposed to the directly coupled field experienced by MR elements 2 and 3. In other words, the MR elements may be positioned so that the resistance of MR elements 1 and 3 may increase and the resistance of MR elements 2 and 4 may decrease as they experience a stronger directly coupled magnetic field. Also, MR elements may be positioned so the resistance of MR elements 5 and 7 may increase and the resistance of MR elements 6 and 8 may decrease as they experience a stronger directly coupled magnetic field.

Considering now the situation where a target and reflected field are present, despite the countercoils 454 and 456, the MR elements 1-8 may experience the reflected field as a uniform field that is common to both bridges. Thus, the reflected field may cause the differential output of the bridge comprising MR elements 1-4 to shift in the same direction as the differential output of the bridge comprising MR elements 5-8. This, the reflected field component can be distinguished from the directly coupled field component of the outputs of the MR bridges by summing or subtracting the differential outputs of the MR bridges.

Referring again to FIG. 4, magnetic field sensor 400 may also include signal processing elements such as amplifiers 416 and 418 to amplify signals 412 and 414, modulators 420 and 422, and analog-to-digital converters (ADC) 424 and 426 to process signals 412 and 414. Modulators 420 and 422 may multiply the signal from the MR elements by a frequency that is substantially the same as the frequency of coil driver 404. This may shift the frequency to DC for subsequent processing.

In accordance with the invention, coil driver 404 drives coil 402 at one frequency (F1) during a first time period and at another frequency (F2) during a second time period. Thus, modulators 420 and 422 may be configured to multiply the signals from the MR elements by frequency F1 during the first time period and by frequency F2 during the second time period. Modulators 420 and 422 may shift the signal to DC by multiplying the signals by the same frequency that drives coil 402.

Magnetic field sensor 400 may also include an MR driver 410 which may provide power to magnetic field sensing elements. MR driver may apply or remove power from either magnetic field sensing element 406 or 408 during alternating time periods. For example, magnetic field sensing element 406 may be active and magnetic field sensing element 408 may be inactive during one time period. During a second time period, magnetic field sensing element 408 may be active and magnetic field sensing element 406 inactive. Alternatively, MR driver may provide power to or remove power from both magnetic field sensing elements 406 and 408 at the same time.

Magnetic field sensor 400 also includes processing circuitry to calculate an error value of the magnetic field sensor. Summation circuit 428 may produce a sum of signal V1 and signal V2. Subtraction circuit 430 may calculate the value V1-V2. Division circuit 432 may divide the signal from summation circuit 428 by the signal from subtraction circuit 430 to produce output signal 434, which may represent the value of (V1 + V2) / (V1 - V2). Recall that V1 may be a digital representation of signal 412 produced by magnetic field sensing element 406 and signal V2 may be a digital representation of signal 414 produced by magnetic field sensing element 408.

Sampling circuits 436 and 438 may selectively couple the output of summation circuit 428 and subtraction circuit 430 to the inputs of division circuit 432, respectively. For example, in an embodiment, the signal (V1+V2) from summation circuit 428 may be sampled during the first time period and the signal (V1-V2) from subtraction circuit 430 may be sampled during the second time period. Accordingly, division circuit may divide the (V1+V2) factor sampled during the first time period by the (V1-V2) factor sampled during the second time period to produce signal 434.

During operation, magnetic field sensor 400 alternates states during a first time period and a second time period. During the first time period, coil driver 404 drives coil 402 with current having a frequency F1. The magnetic field produced by coil 402 induces eddy currents and a reflected magnetic field at frequency F1. Magnetic field sensing elements 406 and 408 detect the directly coupled field from coil 402 and the reflected field from the target during the first time period. As noted above, magnetic field sensing elements may be arranged so that magnetic field sensing elements 406 and 408 detect the directly coupled field with opposite sign, and detect the reflected magnetic field with the same sign.

During the first time period, sampling circuit 436 may allow the signal (V1 + V2) to pass to division circuit 434, while sampling circuit 438 does not pass the signal (V1-V2) to division circuit 434.

During the second time period, coil driver 404 drives coil 402 with current having a frequency F2. The magnetic field produced by coil 402 induces eddy currents and a reflected magnetic field at frequency F2. Magnetic field sensing elements 406 and 408 detect the directly coupled field from coil 402 and the reflected field from the target during the first time period. In embodiments of the invention, frequency F2 is low enough so that it does not induce significant eddy currents or a reflected magnetic field that can be detected by magnetic field sensing elements 406 and 408. In such an embodiment, magnetic field sensing elements 406 and 408 may detect only the directly coupled field during the second time period.

During the second time period, sampling circuit 438 may allow the signal (V1 - V2) to pass to division circuit 434, while sampling circuit 436 does not pass the signal (V1 +V2) to division circuit 434.

After the samples taken during the first and second time periods are available, division circuit 434 may calculate output signal 434, representing (V1+V2)/(V1-V2), where (V1+V2) was sampled during the first time period and (V1-V2) was sampled during the second time period. In embodiments where frequency F2 does not induce a reflected magnetic field during the second time period, the term (V1+V2) may represent the directly coupled and reflected magnetic fields, while the term (V1-V2) may represent only the directly coupled magnetic field.

In embodiments, signal 434 may be used to determine an error of magnetic field of magnetic field sensor 400, e.g. a mismatch error between the magnetic field sensing elements. The error may also be based on noise, interference, external magnetic fields, etc. In some cases, for example when magnetic field sensing elements 406 and 408 are detecting a reflected magnetic field from the target, the magnetic field sensor's error may be a function of the position or distance of the target from magnetic field sensing elements 406 and 408, and the frequency and strength of the reflected magnetic field. For example, the portion of the error due to the reflected field (the "reflected field error") may be a non-linear error. By measuring the directly coupled and reflected field at two frequencies, as described above, magnetic field sensor 400 may compensate for the error due to the reflected field.

In the case where the first frequency F1 and second frequency F2 are non-zero, magnetic field sensor 400 may compensate for the reflected field error by extrapolating or interpolating the magnetic field error using the two frequency points. The technique may also be used in the case where F1 is non-zero and F2 is zero, or low enough so that no reflected field is detectable by magnetic field sensors 406 and 408. In this case, the computations that determine the error value may be simplified because, at one of the frequency points, the reflected field strength is zero. For example, in the example above where F2 is zero, the error value (V1-V2) may not be dependent on the reflected field, and thus not dependent on the position of the target, because no reflected magnetic field is present when the error value (V1-V2) is measured.

In a typical system, V1 and V2 may be described by the following formulas: $V 1 = I \left(T\right) ∗ {K}_{1} ∗ S ∗ \left[\left(1+\frac{{S}_{m}}{2}\right)+r\left(x\right)∗\left(1+\frac{{S}_{m}}{2}\right)\right]$ (1) $V 2 = I \left(T\right) ∗ {K}_{2} ∗ S ∗ \left[q∗\left(1+\frac{{S}_{m}}{2}\right)+r\left(x\right)∗\left(1+\frac{{S}_{m}}{2}\right)\right]$ (2)
where I is the current through coil 402, K₁ and K₂ are coupling factors of the magnetic field sensing elements 406 and 408, respectively, r(x) is a ratio between the reflected field and the directly coupled field, and S is a sensitivity mismatch factor representing a mismatch in sensitivity between magnetic field sensing elements 406 and 408. Note that r(x) may be a function of the position of the target. The value q is a ratio between K₁ and K₂ such that K₂ = q*K₁.

Additionally, the position of the target P_{N} can be described with the following formula: ${P}_{N} = \frac{V 1 + V 2}{V 1 - V 2}$ (3)

Substituting V1 and V2, the formula for P_{N} may be rearranged as: ${P}_{N} = \frac{1 + q + \left(1-q\right) ∗ \frac{{S}_{M}}{2}}{1 - q + \left(1+q+2∗r\left(x\right)\right) ∗ \frac{{S}_{M}}{2}} + \frac{2 ∗ r \left(x\right)}{1 - q + \left(1+q+2∗r\left(x\right)\right) ∗ \frac{{S}_{M}}{2}}$ (4)

Formula 4 may be rewritten as: ${P}_{N} = off + G ∗ r \left(x\right)$ (5)
where: $off = \frac{1 + q + \left(1-q\right) ∗ \frac{{S}_{M}}{2}}{1 - q + \left(1+q+2∗r\left(x\right)\right) ∗ \frac{{S}_{M}}{2}}$ (6) $G = \frac{2}{1 - q + \left(1+q+2∗r\left(x\right)\right) ∗ \frac{{S}_{M}}{2}}$ (7)

If we assume that q = -1 (corresponding to magnetic field sensing elements 406 and 408 detecting the directly coupled magnetic field with opposite signs described above), then formula 4 may be simplified to:
${P}_{N} = \frac{{S}_{M}}{{S}_{M} ∗ r \left(x\right) + 2} + \frac{2 ∗ r \left(x\right)}{{S}_{M} ∗ r \left(x\right) + 2}$ (8)

As an example, if r(x) is 0.5 and S_{M} = 0.01 (representing a 1% mismatch between magnetic field sensing elements), formula 8 gives us:
${P}_{N} = \frac{0.01}{0.01 ∗ 0.5 + 2} + \frac{2 ∗ 0.5}{0.01 ∗ 0.5 + 2} = 0.503$ (9)

This indicates that, in this example, a 1% mismatch between magnetic field sensing elements correlates to a 0.7% error in the position. Moreover, this error may be a function of the position of the target, as shown in formula 4 above. However, time multiplexing and changing the frequency of the magnetic field during operation and calibration can reduce the error in position.

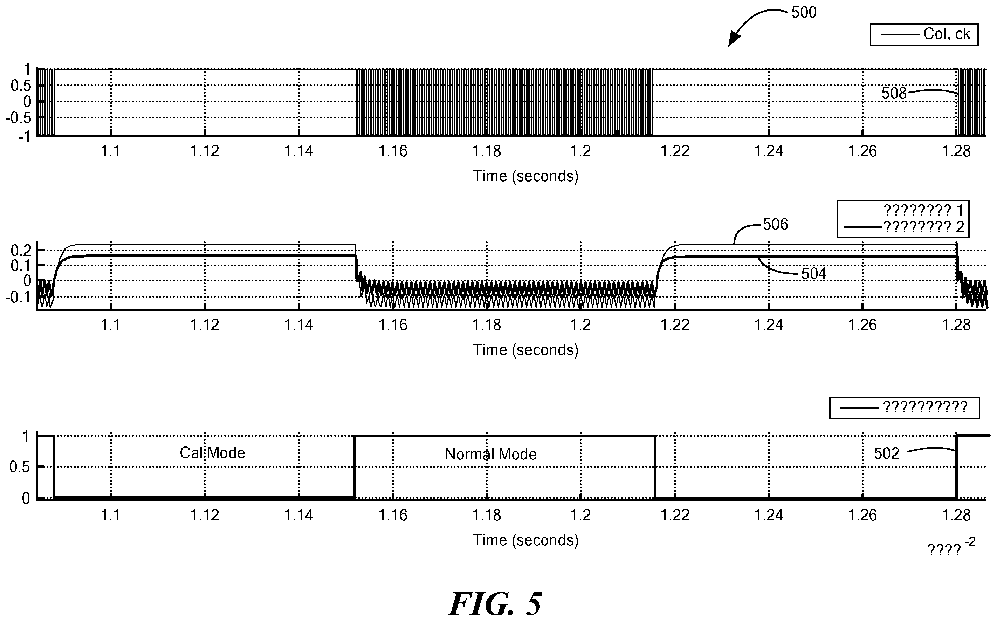

Referring now to FIG. 5, graph 500 illustrates operation of magnetic field sensor 400 during a calibration ("cal") mode and normal operating mode. Waveform 502 represents a control signal that switches magnetic field sensor system 400 between calibration mode and normal mode. Waveform 504 represents signal V1 and waveform 506 represents signal V2. Signal 508 represents the output of coil driver 404. During calibration mode, waveform 508 is a DC waveform, indicating that the magnetic field produced by coil 402 has a zero frequency. Thus, during calibration mode, the target may not produce a reflected magnetic field. As shown, waveform 504 and 506 (corresponding to signals V1 and V2) may also be DC waveforms.

During calibration mode, the error value (V1-V2) may be calculated, as described above. Because (V1-V2) is calculated during calibration mode, the term (V1-V2) may not include measurements of the reflected magnetic field and may not include errors due to position of the target.

During normal mode, the term (V1 + V2) may be calculated, as described above. Because (V1+V2) is calculated during normal mode, the term (V1+V2) may include measurements of the reflected magnetic field and thus may include errors due to position of the target.

In embodiments, magnetic field sensor 400 may alternate operation between calibration mode and normal mode. In other embodiments, because the measurements taken during calibration mode do not depend on the reflected field, magnetic field sensor 400 may operate in calibration mode less frequently than in normal mode. In some embodiments, calibration mode may only be performed once during startup and the term (V1-V2) may be stored and reused during calculation of the system error. In other words: ${\left[V1-V2\right]}_{T 1} = {\left[V1-V2\right]}_{T 2}$ (10)

Where T1 corresponds to the normal mode and T2 corresponds to calibration mode. Using formulas 5 and 10, we can derive: ${P}_{N} = \frac{{\left[V1+V2\right]}_{T 1}}{{\left[V1-V2\right]}_{T 2}} = off + G ′ ∗ r \left(x\right)$ (11) $off = \frac{1 + q + \left(1-q\right) \frac{{S}_{M}}{2}}{1 - q}$ (12) $G ′ = \frac{2}{1 - q}$ (13)

The terms *off* and G' are both independent of r(x), and thus independent of error due to position of the target. Thus, the target position P_{N} may be calculated without the inclusion of the nonlinearity error due to target position.

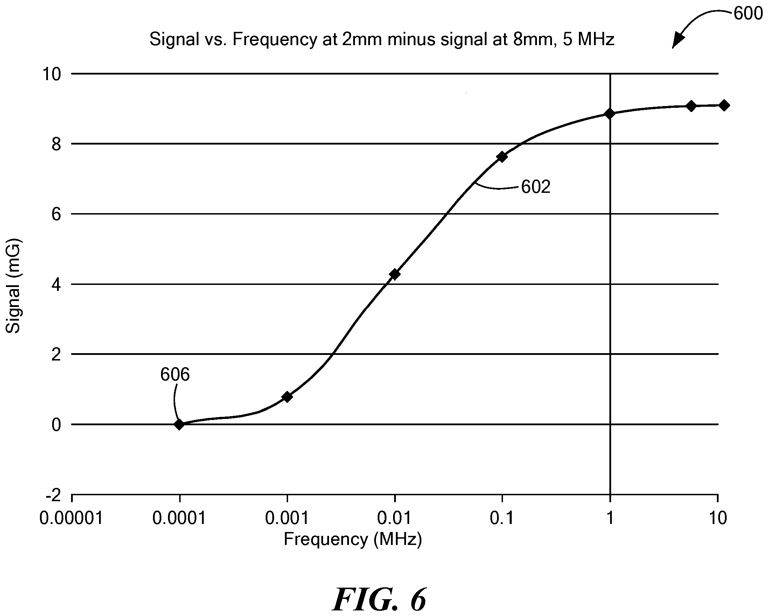

Referring now to FIG. 6, graph 600 includes a waveform 602 representing detection of the reflected magnetic field versus frequency of the signal driving coil 402. The horizontal axis represents frequency and the vertical axis represents milli-Gauss of reflected magnetic field detected by the magnetic field sensing elements. The frequency is chosen to be sufficiently low so that during calibration mode the detected reflected field is negligible. In the example shown, a frequency of 0.0001 MHz or less may result in zero reflected magnetic field, as shown by point 606. In embodiments, higher frequencies may be used if the resulting reflected magnetic field is negligible or within system tolerances for measuring the system's error.

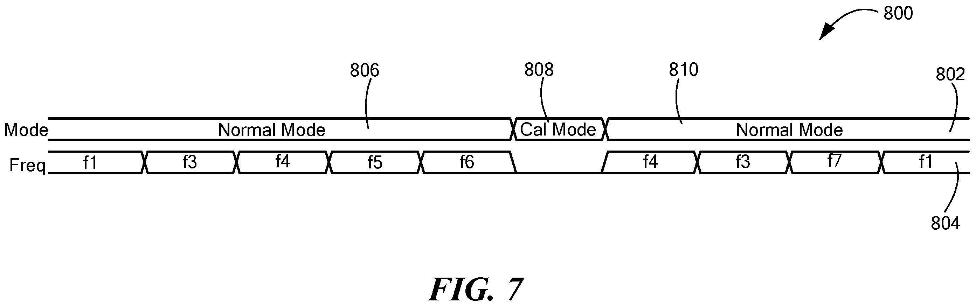

Referring to FIG. 7, graph 800 illustrates timing between calibration mode and normal mode where different frequencies are used to drive coil 402 during normal mode. If coil 402 is driven at a single frequency, magnetic field sensor may radiate emissions at that frequency. Varying the frequency driving coil 402 during normal mode may, in certain cases, reduce or vary the frequency of radiated emissions of the device.

In FIG. 7, waveform 802 indicates normal mode or calibration mode, and waveform 804 represents the frequency driving coil 402. During the first calibration mode 806, the frequency 804 may switch between f1, f3, f4, f5, f6, etc. During calibration mode 808, coil 402 may be driven by a DC signal, as described above. When the magnetic field sensor again enters a normal operating mode 810, the frequency may switch between f4, f3, f7, f1, etc. In other embodiments, each calibration mode may drive coil 402 at a single frequency, but the frequency may change with each calibration mode. Also, FIG. 7 shows a particular sequence of changing frequencies. However, one skilled in the art will recognize that any sequence or pattern of changing frequencies may be used.

Having described preferred embodiments, which serve to illustrate various concepts, structures and techniques, which are the subject of this patent, it will now become apparent to those of ordinary skill in the art that other embodiments incorporating these concepts, structures and techniques may be used. Accordingly, it is submitted that that scope of the patent should not be limited to the described embodiments but rather should be limited only by the following claims.

## Claims

1. A system comprising:
at least one coil configured to alternately generate:
a first magnetic field having a first non-zero frequency; and
a second magnetic field having a second frequency;
a conductive target positioned to generate a reflected magnetic field in response to the first magnetic field;
two or more magnetic field sensing elements (306, 406, 408) configured to:
produce a first signal representing detection of the first magnetic field and the reflected magnetic field; and
produce a second signal representing detection of the second magnetic field; and
a processing circuit to receive the first and second signals and calculate an error value of the system as a function of the first and second signals;
wherein the first magnetic field has a frequency sufficiently high to induce an eddy current in the conductive target that produces the reflected magnetic field;
wherein the second frequency is substantially low so that it does not induce a reflected field from the conductive target;
wherein the first magnetic field is generated during a first time period and the second magnetic field is generated during a second time period; and
wherein the calculated error value is independent of a position of the conductive target.

2. A method for calculating the error value of a system, comprising:
alternately generating:
a first magnetic field having a first, non-zero frequency; and
a second magnetic field having a second frequency;
inducing, by the first magnetic field, a reflected magnetic field from a conductive target;
producing a first signal, by two or more magnetic field sensing elements (306, 406, 408), representing the first magnetic field and the reflected magnetic field;
producing a second signal, by the two or more magnetic field sensing elements (306, 406, 408), representing the second magnetic field; and
calculating an error value of the system as a function of the first and second signals;
wherein first magnetic field has a frequency sufficiently high to induce an eddy current in the conductive target, wherein the reflected magnetic field is produced by the eddy current;
wherein the second frequency is substantially low so that the second magnetic field does not induce a reflected magnetic field from the conductive target;
wherein:
generating the first magnetic field comprises generating the first magnetic field during a first time period;
generating the second magnetic field comprises generating the second magnetic field during a second time period; and
the calculated error value is independent of a position of the conductive target.

3. The method of claim 2, or the system of claim 1, wherein the second frequency is substantially zero.

4. The method of claim 2, or the system of claim 1 wherein the first and second time periods are non-overlapping time periods.

## Patentansprüche

1. System, umfassend:
mindestens eine Spule, die dazu konfiguriert ist, abwechselnd Folgendes zu generieren:
ein erstes Magnetfeld mit einer ersten Nicht-Null-Frequenz; und
ein zweites Magnetfeld mit einer zweiten Frequenz;
ein leitfähiges Ziel, das so positioniert ist, dass es ein reflektiertes Magnetfeld als Reaktion auf das erste Magnetfeld generiert;
zwei oder mehr Magnetfelderfassungselemente (306, 406, 408), die zu Folgendem konfiguriert sind:
Erzeugen eines ersten Signals, das die Erkennung des ersten Magnetfelds und des reflektierten Magnetfelds darstellt; und
Erzeugen eines zweiten Signals, das die Erkennung des zweiten Magnetfelds darstellt;
und
eine Verarbeitungsschaltung zum Empfangen des ersten und des zweiten Signals und zum Berechnen eines Fehlerwerts des Systems als eine Funktion des ersten und des zweiten Signals;
wobei das erste Magnetfeld eine Frequenz aufweist, die ausreichend hoch ist, um einen Wirbelstrom in dem leitfähigen Ziel zu induzieren, der das reflektierte Magnetfeld erzeugt;
wobei die zweite Frequenz im Wesentlichen niedrig ist, sodass sie kein reflektiertes Feld von dem leitfähigen Ziel induziert;
wobei das erste Magnetfeld während eines ersten Zeitraums generiert wird und das zweite Magnetfeld während eines zweiten Zeitraums generiert wird; und
wobei der berechnete Fehlerwert unabhängig von einer Position des leitfähigen Ziels ist.

2. Verfahren zum Berechnen des Fehlerwertes eines Systems, umfassend:
abwechselndes Generieren:
eines ersten Magnetfelds mit einer ersten Nicht-Null-Frequenz; und
eines zweiten Magnetfelds mit einer zweiten Frequenz;
Induzieren eines reflektierten Magnetfelds von einem leitfähigen Ziel durch das erste Magnetfeld;
Erzeugen eines ersten Signals durch zwei oder mehr Magnetfelderfassungselemente (306, 406, 408), das das erste Magnetfeld und das reflektierte Magnetfeld darstellt;
Erzeugen eines zweiten Signals durch die zwei oder mehr Magnetfelderfassungselemente (306, 406, 408), das das zweite Magnetfeld darstellt; und
Berechnen eines Fehlerwerts des Systems als eine Funktion des ersten und des zweiten Signals;
wobei erstes Magnetfeld eine Frequenz aufweist, die ausreichend hoch ist, um einen Wirbelstrom in dem leitfähigen Ziel zu induzieren, wobei das reflektierte Magnetfeld durch den Wirbelstrom erzeugt wird;
wobei die zweite Frequenz im Wesentlichen niedrig ist, sodass das zweite Magnetfeld kein reflektiertes Magnetfeld von dem leitfähigen Ziel induziert;
wobei:
das Generieren des ersten Magnetfelds Generieren des ersten Magnetfelds während eines ersten Zeitraums umfasst;
das Generieren des zweiten Magnetfelds Generieren des zweiten Magnetfelds während eines zweiten Zeitraums umfasst; und
der berechnete Fehlerwert unabhängig von einer Position des leitfähigen Ziels ist.

3. Verfahren nach Anspruch 2 oder System nach Anspruch 1, wobei die zweite Frequenz im Wesentlichen null ist.

4. Verfahren nach Anspruch 2 oder System nach Anspruch 1, wobei der erste und der zweite Zeitraum nicht überlappende Zeiträume sind.

## Revendications

1. Système comprenant :
au moins une bobine conçue pour générer alternativement :
un premier champ magnétique possédant une première fréquence non nulle ; et
un second champ magnétique possédant une seconde fréquence ;
une cible conductrice positionnée pour générer un champ magnétique réfléchi en réponse au premier champ magnétique ;
deux, ou plus, éléments de détection de champ magnétique (306, 406, 408) conçus pour :
produire un premier signal représentant la détection du premier champ magnétique et
du champ magnétique réfléchi ; et
produire un second signal représentant la détection du second champ magnétique ; et
un circuit de traitement pour recevoir les premier et second signaux et calculer une valeur d'erreur du système en fonction des premier et second signaux ;
ledit premier champ magnétique possédant une fréquence suffisamment élevée pour induire un courant de Foucault dans la cible conductrice qui produit le champ magnétique réfléchi ;
ladite seconde fréquence étant sensiblement basse de sorte qu'elle n'induise pas de champ réfléchi provenant de la cible conductrice ;
ledit premier champ magnétique étant généré durant une première période de temps et ledit second champ magnétique étant généré durant une seconde période de temps ; et
ladite valeur d'erreur calculée étant indépendante d'une position de la cible conductrice.

2. Procédé permettant le calcul de la valeur d'erreur d'un système, comprenant :
la génération de manière alternative de :
un premier champ magnétique possédant une première fréquence non nulle ; et
un second champ magnétique possédant une seconde fréquence ;
l'induction, par le premier champ magnétique, d'un champ magnétique réfléchi provenant d'une cible conductrice ;
la production d'un premier signal, par deux, ou plus, éléments de détection de champ magnétique (306, 406, 408), représentant le premier champ magnétique et le champ magnétique réfléchi ;
la production d'un second signal, par les deux, ou plus, éléments de détection de champ magnétique (306, 406, 408), représentant le second champ magnétique ; et le calcul d'une valeur d'erreur du système en fonction des premier et second signaux ;
ledit premier champ magnétique possédant une fréquence suffisamment élevée pour induire un courant de Foucault dans la cible conductrice, ledit champ magnétique réfléchi étant produit par le courant de Foucault ;
ladite seconde fréquence étant sensiblement basse de sorte que le second champ magnétique n'induise pas de champ magnétique réfléchi provenant de la cible conductrice ;
ladite génération du premier champ magnétique comprenant la génération du premier champ magnétique durant une première période de temps ;
ladite génération du second champ magnétique comprenant la génération du second champ magnétique durant une seconde période de temps ; et
ladite valeur d'erreur calculée étant indépendante d'une position de la cible conductrice.

3. Procédé de la revendication 2, ou système de la revendication 1, ladite seconde fréquence étant sensiblement nulle.

4. Procédé de la revendication 2, ou système de la revendication 1, lesdites première et seconde périodes de temps étant des périodes de temps sans chevauchement.
